# EUROPEAN PATENT APPLICATION

(11) **EP 1 278 235 A1**
(43) Date of publication of application: **22.01.2003**
(21) Application number: 02014978.7
(22) Date of filing: 09.07.2002
(51) Int. Cl.: H01L 21/304, H01L 21/00, B28D 5/00, H01L 29/04

(54) **Manufacturing method of compound semiconductor device**

(30) Priority: 09.07.2001 JP 2001207652
(71) Applicant: Sanyo Electric Co., Ltd., Moriguchi-shi, Osaka 570-8677 (JP)
(72) Inventor: Asano, Tetsuro, Ora-gun, Gunma-ken (JP); Uekawa, Masahiro, Ora-gun, Gunma-ken (JP); Hirata, Koichi, Ashikaga-city, Tochigi (JP); Sakakibara, Mikito, Osato-gun, Saitama (JP)
(74) Representative: Glawe, Delfs, Moll & Partner

(57) **Abstract**

In a method of manufacturing a compound semiconductor device, individual chip patterns (3) are projected onto a (1 0 0) surface of a GaAs wafer (2) so that the columns and rows of the chip patterns (3) are aligned in a direction slanting by 45 degrees with respect to a [0 1 1] direction of the GaAs wafer (2). The wafer (2) is diced along this slanting direction and chipping along the edges of the individual separated chips is greatly reduced.

## Description

### BACKGROUND OF THE INVENTION

### Field of the Invention

The invention relates to a manufacturing method of compound semiconductor device operating at high frequencies, specifically to a method which prevents chipping of compound semiconductor substrate during dicing process.

### Description of the Related Art

The demand for high frequency devices has been rapidly increasing due to the expanding market for portable telephones and digital satellite communication equipment. Many of such devices include field effect transistors (referred to as FET, hereinafter) employing a gallium arsenide (referred to as GaAs, hereinafter) substrate because of its excellent high frequency characteristics. Typical application in this field includes local oscillation FETs and monolithic microwave integrated circuits (MMIC) in which a plurality of FETs are integrated.

In a typical semiconductor device manufacturing process, a semiconductor wafer in which semiconductor devices have been formed must be separated into individual devices. The most popular method to cut the wafer is to use a dicing saw. Such a method is well know and described in may publications including Japanese Laid Open Patent Publication No. Sho 60-34827.

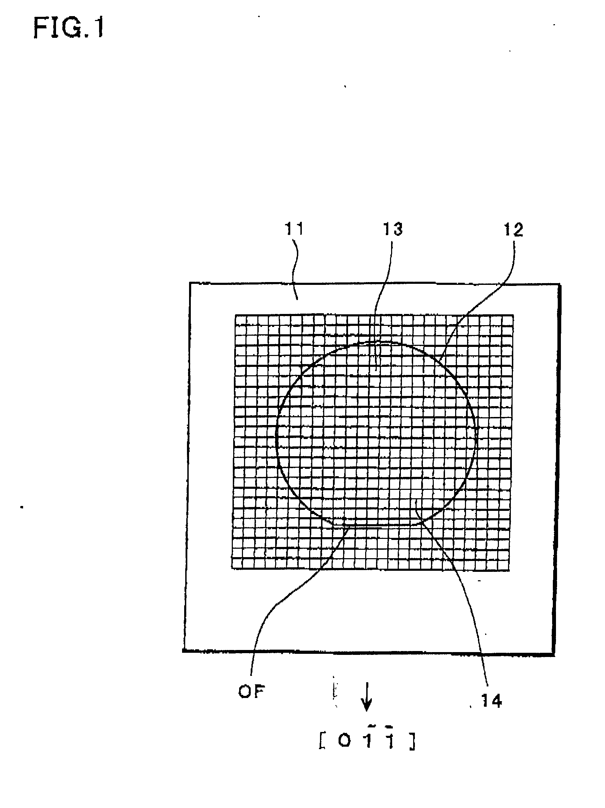

FIG. 1 shows a conventional alignment of a GaAs wafer 12 with respect to a mask 11 having individual chip patterns 13. The GaAs wafer 12 is positioned with respect to the mask 11 using an orientation flat OF of the GaAs wafer as a positioning reference. Specifically, an edge of the mask 11 and the orientation flat OF is aligned so that the two directions are parallel to each other or perpendicular to each other. In such a configuration, all the chip patterns are aligned in directions parallel to and perpendicular to the edge of the mask 11. As indicated by an arrow in FIG. 1, the orientation flat OF is generally formed in a direction normal to a [0 î î] direction of the GaAs lattice. The surface of the GaAs wafer 12 is a (1 0 0) plane of the GaAs lattice and is exposed in a photolithographic process to form semiconductor devices such as GaAs FETs. The notation of surfaces and planes described in this specification is based on Miller indices.

During a dicing process of the GaAs wafer 12, a dicing blade is first positioned on a dicing region 14 formed on the primary plane of the GaAs wafer 12, and then cuts the GaAs wafer 12 along the dicing region 14. Because of chipping, a typical width of the dicing region 14 is 50 µm. Other operational parameters of dicing blades in this process include a cutting speed of about 6 mm/sec and a blade spin rate of about 30000 to 35000 rpm. After dicing, the GaAs wafer 12 which have been cut by the dicing blade is rinsed with water and then dried before being sent to a bonding process.

According to this conventional alignment of the mask, the chip patterns and the wafer, the wafer is diced in a direction parallel to or normal to the [0 î î] direction of the wafer. On a (1 0 0) plane of the GaAs lattice, the cleavage direction is either parallel to or normal to the [0 î î] direction. Thus, when the wafer is cut along a direction parallel to the [0 î î] direction, cleavage may easily occur along a direction normal to the cutting direction. Accordingly, when the GaAs wafer 12 is diced along this direction, a large amount of chipping occurs along this direction because of the cleavage induced by stresses generated at a contact between the rotating dicing blade and the surface of the GaAs wafer 12. Chipping is a crack formation at the surface cut by the dicing blade and leads to reduced yield of the manufacturing process. Because of the chipping, the width of the dicing region 14 should be wider than otherwise required, or the cutting speed should be slow so as not to induce a large amount of chipping.

It is known in the art that chipping of a compound semiconductor substrate is greatly reduced when the substrate is diced along a direction slanting by 45 degrees with respect to a cleavage direction. Accordingly, it is possible to reduce such chipping if the chip patterns of the mask are aligned in a direction slanting by 45 degrees with respect to the cleavage direction. Such a process need be preformed using an alignner, which projects all the chip patterns of the mask onto the wafer at the same time.

However, alignners cannot provide spatial resolution sufficient for advanced devices with fine design rules, including GaAs FETs which requires a controlled gate length and an accurate positioning of source, drain and gate regions. Especially, projection accuracy of the alignner at peripheral portions of the wafer is very limited.

Although a step and repeat demagnification apparatus can provide the necessary spatial resolution, such an apparatus can have the wafer step only in a direction parallel to or perpendicular to the direction of the orientation flat. Because most of the common compound semiconductor wafers have the orientation flat normal to a [0 î î] direction of GaAs, the individual chips formed on the wafer by the step and repeat apparatus are inevitably cut in parallel to or perpendicular to the cleavage direction.

### SUMMARY OF THE INVENTION

It is an object of this invention to provide a manufacturing method of compound semiconductor devices that allows a higher yield.

The solution according to the invention lies in the features of the independent claims and preferably in those of the dependent claims. The invention provides a manufacturing method of compound semiconductor device including providing a wafer of a compound semiconductor. The primary surface of the wafer is a (1 0 0) surface of the compound semiconductor. The wafer has an orientation flat in a [0 î 0], [0 0 î], [0 0 1] or [0 1 0] direction of the compound semiconductor. The method also includes patterning the wafer and dicing the wafer.

The invention also provides a manufacturing method of compound semiconductor device including providing a wafer of a compound semiconductor having a primary surface, which comprises a (1 0 0) surface of the compound semiconductor or its crystallographically equivalent surface. The method also includes providing a reticle having individual chip patterns and positioning the reticle with respect to the wafer so that the individual chip patterns of the reticle are aligned in a direction slanting with respect to a [0 1 1] direction of the compound semiconductor or its crystallographically equivalent direction thereof. The method further includes patterning the wafer using the reticle positioned with respect to the wafer and dicing the patterned wafer in the direction slanting with respect to a [0 1 1] direction of the compound semiconductor or the crystallographically equivalent direction.

### BRIEF DESCRIPTION OF THE DRAWINGS

- FIG. 1: shows an alignment of a mask and a wafer used in a conventional method of manufacturing compound semi-conductor device.
- FIG. 2: shows an alignment of a mask and a wafer having a [0 î 0] direction used in an embodiment of a method of manufacturing compound semiconductor device of this invention.
- FIG. 3A: is a top view showing a crystallographic structure of GaAs, and FIG. 3B is a perspective view showing the crystallographic structure of GaAs of FIG. 3A.
- FIG. 4: shows an alignment of a mask and a wafer having a [0 0 î] direction used in the embodiment.
- FIG. 5: shows an alignment of a mask and a wafer having a [0 0 1] direction used in the embodiment.
- FIG. 6: shows an alignment of a mask and a wafer having a [0 1 0] direction used in the embodiment.

### DETAILED DESCRIPTION OF THE INVENTION

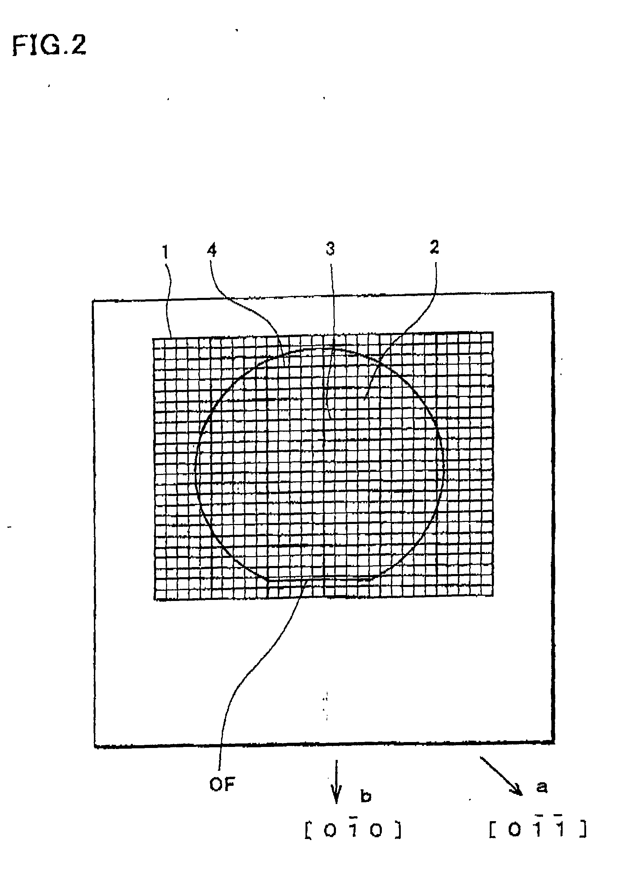

An embodiment of a manufacturing method of compound semiconductor device of this invention is described with reference to FIGS. 2-6. FIG.2 shows an alignment of a reticle 1 and a wafer 2 used in this embodiment. The reticle 1 has chip patterns 3 for exposing circuit patterns onto a surface of the wafer 2 during a photolithographic process with a step and repeat demagnification apparatus. The chip patterns 3 are adapted to align with a direction slanting by 45 degrees with respect to the cleavage direction of the wafer 2 [0 î î] when the reticle 1 is positioned over the wafer 2 for exposure.

In this embodiment, the chip patterns 3 of the reticle 1 are exposed onto the wafer 2 by a step and repeat procedure, in which each of the chip patterns 3 is positioned for exposure being moved parallel to and perpendicular to the direction of the orientation flat. Because of the step and repeat procedure, projection characteristics at the peripheral portion of the wafer 2 are improved and positioning accuracy of source, drain and gate regions over the entire wafer 2 is also improved. The reticle itself 1 is automatically manufactured based on CAD data, and has chip patterns 3 aligned in the directions of the edges of the reticle 1.

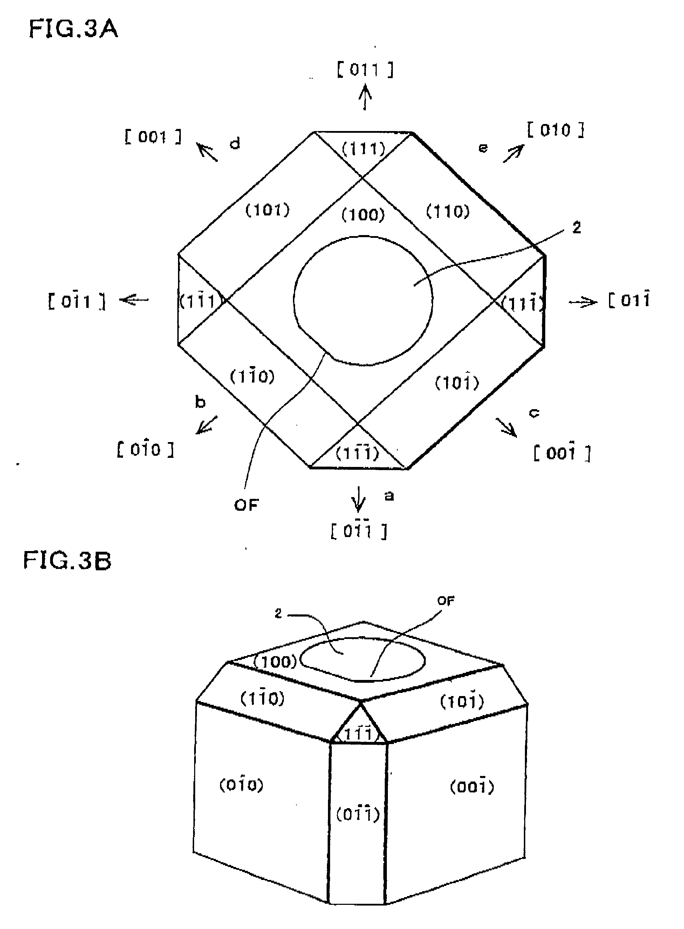

FIG. 3A is a top view showing a crystallographic structure of GaAs having a zincblende lattice, and FIG. 3B is a perspective view showing the crystallographic structure of GaAs of FIG. 3A. A crystallographic direction of a wafer 2 is a direction normal to a side surface of the GaAs structure. As shown in FIG. 3A, there are eight such directions in the GaAs structure. The orientation flat is formed to indicate this crystallographic direction so that a direction normal to the orientation flat within the plane of the wafer 2 corresponds to the crystallographic direction.

In this embodiment, the crystallographic direction of the wafer 2 is [0 î 0], and the orientation flat is formed normal to this direction, as shown in FIG. 2. Accordingly, in the configuration shown in FIG. 2, the orientation flat is aligned in a direction slanting by 45 degrees with respect to the cleavage direction [0 î î]. In FIGS. 2, 3A and 3B, arrows a and b indicate the [0 î î] direction and the [0 î 0] direction, respectively. Because the chip patterns 3 are aligned parallel to or perpendicular to the orientation flat, an step and repeat apparatus can be used to expose the wafer 2 while keeping the cleavage direction slanting by 45 degrees with respect to the direction of the alignment of the chip patterns 3.

After completion of device formation on the surface of the wafer 2 following the exposure step, the wafer 2 is diced in the direction slanting by 45 degrees with respect to the cleavage direction of the wafer 2. In this step, the wafer 2 is, first, attached to a tape cut ring through a dicing sheet. Then, a dicing blade is positioned on a dicing region 4 of the wafer 2, and cuts the primary plane of the wafer 2 in the direction of the dicing region, i.e., the direction slanting by 45 degrees with respect to cleavage direction. When the wafer 2 is cut along this direction, chipping is greatly reduced on all edges of the device chip. Accordingly, the width of the dicing region 4 is reduced by 10 µm to 40 µm in comparison to the conventional manufacturing method shown in FIG. 1.

Furthermore, the cutting speed may be increased five to six times as high as that of conventional method. In this embodiment, the wafer 2 was cut with dicing conditions including a cutting speed of about 30 to 40 mm/sec and a blade spin rate of about 30000 to 35000 rpm, which are similar to the dicing conditions of silicon wafer.

After the dicing step, the individual chips of the wafer 2 are separated from each other by expanding the dicing sheet, and rinsed with water. After drying, the individual chips are sent to the next process, i.e., a bonding process.

As described above, dicing a primary surface of a compound semiconductor wafer having a (1 0 0) surface in a direction slanting by 45 degrees with respect to a [0 î î] direction of the wafer greatly reduces chipping along all edges of the individual chips. Accordingly, overall production yield increases because of reduced chipping, and effective use of expensive compound semiconductor wafer is achieved because of narrower dicing region. Furthermore, narrowing of the dicing region leads to smaller size of the device.

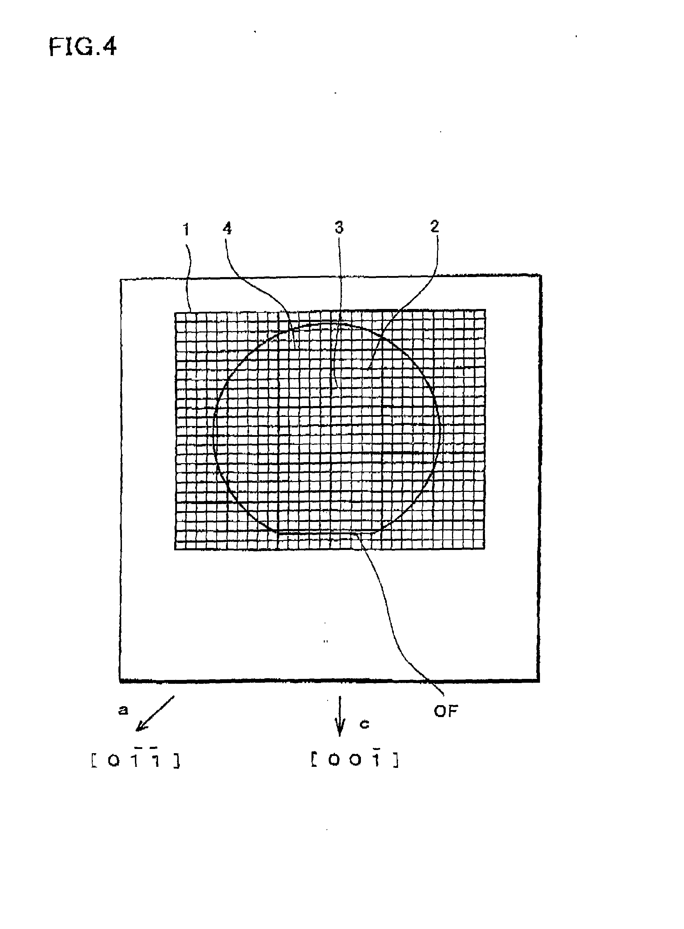

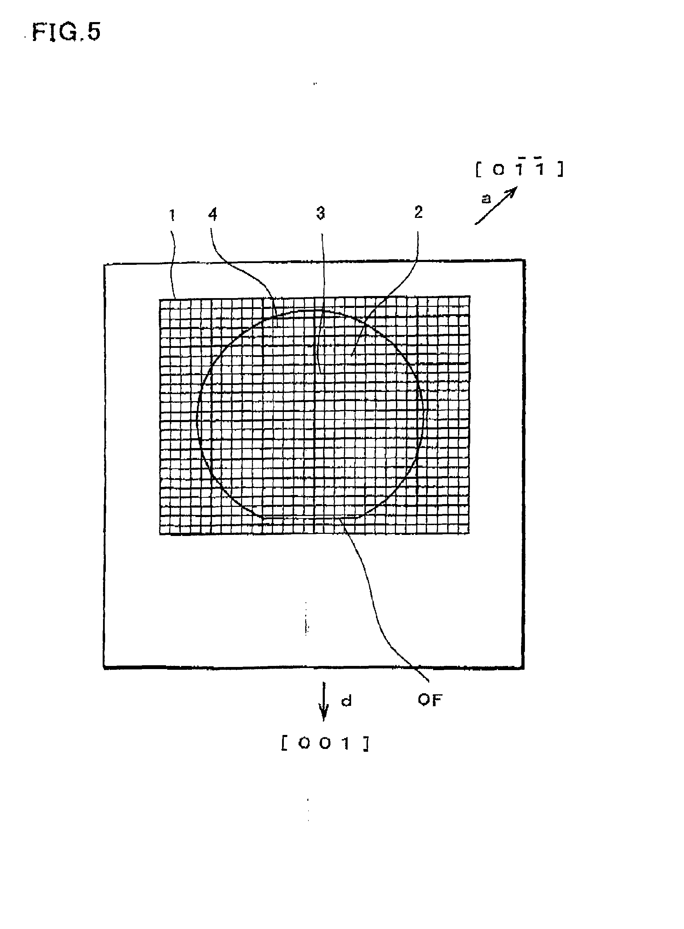

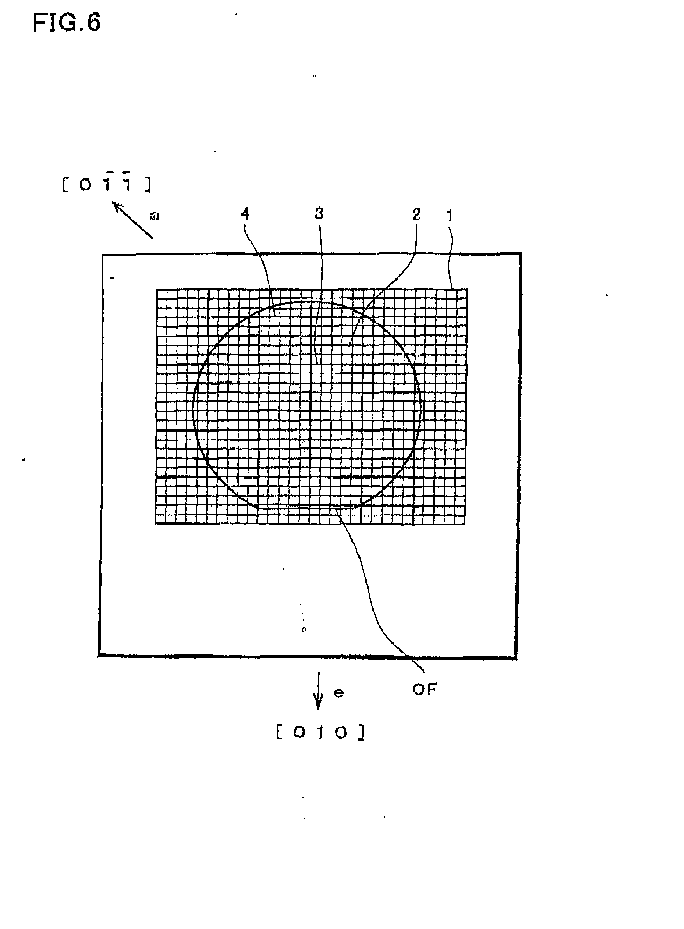

In this embodiment, the crystallographic direction of the wafer is [0 î 0]. However, wafers of other crystallographic directions may be used as long as the cleavage direction [0 î î] slants with respect to the orientation flat. Those directions includes a [0 0 î] direction (arrow c in FIGS. 3A, 3B and 4), a [0 0 1] direction (arrow d in FIGS. 3A, 3B and 5) and a [0 1 0] direction (arrow e in FIGS. 3A, 3B and 6). Those four directions have an identical effect on reducing the chipping during the dicing step.

Furthermore, the slanting angle between the alignment direction of the chip patterns and the cleavage direction [0 î î] is 45 degrees. However, the slanting angle is not limited to this angle, but may be larger or smaller than this angle as long as the reduction of chipping is significantly reduced. For example, it maybe any angle between 30 and 60 degrees. Furthermore, the manufacturing method of this embodiment is not only applicable to formation of FETs on GaAs substrate, but also applicable to formation of MMIC and Schottky barrier diode, among other devices. The GaAs substrate may be replaced by other compound semiconductor substrate having a similar crystallographic structure.

The above is a detailed description of a particular embodiment of the invention which is not intended to limit the invention to the embodiment described. It is recognized that modifications within the scope of the invention will occur to a person skilled in the art. Such modifications and equivalents of the invention are intended for inclusion within the scope of this invention.

## Claims

1. A manufacturing method of compound semiconductor device comprising:
- providing a wafer (2) of a compound semiconductor, a primary surface of the wafer (2) comprising a (1 0 0) surface of the compound semiconductor, the wafer having an orientation flat in a [0 î 0], [0 0 î], [0 0 1] or [0 1 0] direction of the compound semiconductor;
- patterning the wafer (2); and
- dicing the wafer (2).

2. A manufacturing method of compound semiconductor device comprising:
- providing a wafer (2) of a compound semiconductor having a primary surface, which comprises a (1 0 0) surface of the compound semiconductor or a crystallographically equivalent surface thereof;
- providing a reticle (1) having individual chip patterns (3);
- positioning the reticle (1) with respect to the wafer (2) so that the individual chip patterns (3) of the reticle (1) are aligned in a direction slanting with respect to a [0 1 1] direction of the compound semiconductor or a crystallographically equivalent direction thereof;
- patterning the wafer (2) using the reticle (1) positioned with respect to the wafer (2); and
- dicing the patterned wafer (2) in the direction slanting with respect to the [0 1 1] direction of the compound semiconductor or the crystallographically equivalent direction thereof.

3. The manufacturing method of claim 2, wherein a slanting angle of the individual chip patterns (3) with respect to the [0 1 1] direction of the compound semiconductor or the crystallographically equivalent direction thereof is between 30 and 60 degrees.

4. The manufacturing method of claim 2, wherein the wafer (2) has an orientation flat configured to align in a direction of an alignment of the individual chip patterns (3).

5. The manufacturing method of claim 2, wherein the positioning of the reticle (1) with respect to the wafer (2) and the patterning of the reticle (1) are performed by a step and repeat demagnification exposure apparatus.

6. The manufacturing method of claim 2, wherein the compound semiconductor comprises GaAs.

7. The manufacturing method of claim 2, wherein the compound semiconductor comprises a zincblende lattice.
